# FASCICULE DE BREVET EUROPEEN

(11) **EP 1 502 353 B1**
(45) Date de publication et mention de la délivrance du brevet: **02.10.2013**
(21) Numéro de dépôt: 03740687.3
(22) Date de dépôt: 30.04.2003
(51) Int. Cl.: H03G 1/00

(54) **MONTAGE AMPLIFICATEUR A GAIN VARIABLE ET FAIBLE BRUIT A GRANDE DYNAMIQUE**
RAUSCHARMER VERSTÄRKER MIT VARIABLER VERSTÄRKUNG UND HOHER DYNAMIK
WIDE-DYNAMIC-RANGE, VARIABLE-GAIN, LOW-NOISE AMPLIFIER CIRCUIT

(30) Priorité: 03.05.2002 FR 0205577
(43) Date de publication de la demande: 02.02.2005
(73) Titulaire: Thales Ultrasonics SAS, 75008 Paris (FR)
(72) Inventeur: POMATA, Francesco Thales Intellectual Property, F-94117 Arcueil Cedex (FR); MONINI, Didier Thales Intellectual Property, F-94117 Arcueil Cedex (FR)
(74) Mandataire: Esselin, Sophie
(86) Numéro de dépôt international: PCT/FR2003/001363
(87) Numéro de publication internationale: WO 2003/096528

(56) Documents cités:
- EP-A- 0 622 896
- DE-A- 1 907 579
- PATENT ABSTRACTS OF JAPAN vol. 2000, no. 23, 10 février 2001 (2001-02-10) & JP 2001 156567 A (ALPS ELECTRIC CO LTD), 8 juin 2001 (2001-06-08)

## Description

La présente invention telle que définie dans la revendication indépendante 1 se rapporte à un montage amplificateur à gain variable et faible bruit à grande dynamique.

Des montages amplificateurs à gain variable et faible bruit sont utilisés, entre autres, dans des échographes. Les échos recueillis par les sondes ultrasonores de ces échographes sont tous de faible niveau, et le rapport entre le niveau des échos les plus faibles et celui des échos les moins faibles peut être très important (plus de 100 dB). Pour réaliser des amplificateurs dont le gain puisse s'adapter à une telle dynamique, on leur associe des composants à grande variation de réactance. Ces composants sont des diodes à capacité variant en fonction de la tension qui leur est appliquée, connues sous la dénomination de « Varicaps ». La plage de variation de capacité des varicaps courantes n'est pas très étendue. Seules des varicaps spéciales, très onéreuses, conviendraient, et elles sont d'autant plus onéreuses que la technologie habituelle de fabrication de ces diodes est de type BICmos, ce qui oblige à sélectionner dans une série de fabrication celles ayant la plus grande plage de variation de capacité.

On connait d'après le document EP-A-0 622 896 un amplificateur à circuits d'égalisation pour plusieurs bandes étroites : les différents amplificateurs opérationnels qu'il comprend se comportent en filtres passe-bande (colonne 4, lignes 53-56), et les éléments réactifs branchés sur ces amplificateurs sont de simples condensateurs.

On connait d'après le document DE 19 07 579 A (Siemens) un montage amplificateur à gain variable comportant entre la sortie de son amplificateur et son entrée inverseuse une première impédance, et entre cette même entrée inverseuse et la source de signaux à amplifier une deuxième impédance, ces impédances étant des impédances réactives capacitives, l'une d'elles au moins étant variable. Dans ce montage connu, la deuxième impédance se trouve en série avec l'impédance de la source de signaux, ce qui fait que le gain du montage est dépendant de l'impédance de la source. Lorsque cette source est une sonde d'échographe (fonctionnant à des fréquences de plusieurs MHz), son impédance n'est pas capacitive, et le gain du montage varie fortement en fonction de la fréquence si l'on veut que ce montage soit à très faible bruit. En effet, pour que le gain soit pratiquement indépendant de la fréquence, il faudrait que la valeur de la deuxième impédance soit beaucoup plus élevée que celle de la sonde. Dans ce cas, le bruit produit par l'amplificateur (ce bruit est sensiblement proportionnel à l'impédance d'entrée) serait beaucoup trop important. En outre, si la valeur de la deuxième impédance était beaucoup plus élevée que celle de la source, le gain de l'amplificateur serait limité, car, pour avoir un gain élevé, il faudrait que la valeur de la première impédance soit beaucoup plus élevée que celle de la deuxième (qui devrait être elle-même beaucoup plus élevée que celle de la source), ce qui obligerait à avoir des valeurs trop élevées pour les deux premières impédances, et leur comportement en hautes fréquences serait très difficile à maîtriser..

La présente invention a pour objet un montage amplificateur à gain variable à faible bruit, dont la variation de gain ait la plus grande dynamique possible, ce gain étant le moins dépendant possible de la fréquence des signaux à amplifier et de l'impédance de sortie de la source de ces signaux, et qui permette d'utiliser des composants réactifs couramment disponibles à faible plage de variation de réactance, ces composants pouvant être réalisés selon une technologie classique telle que BICmos.

Le montage amplificateur conforme à l'invention, du type à amplificateur opérationnel dont la sortie est reliée par un premier élément réactif à une de ses entrées, cette entrée étant par ailleurs reliée par un deuxième élément réactif à un pôle commun de l'alimentation de l'amplificateur, est caractérisé en ce que l'entrée de l'amplificateur à laquelle sont reliés les deux éléments réactifs est son entrée inverseuse, et que son entrée non inverseuse est reliée à la source de signaux à amplifier. De préférence, les éléments réactifs sont des éléments à capacité variable, de préférence des Varicaps. De préférence, chaque élément à capacité variable comporte au moins deux varicaps.

La présente invention sera mieux comprise à la lecture de la description détaillée d'un mode de réalisation, pris à titre d'exemple non limitatif et illustré par le dessin annexé, sur lequel :
- la figure 1 est un schéma simplifié d'un circuit à amplificateur opérationnel pouvant être monté en amplificateur à gain variable, et dont deux éléments seront remplacés pour constituer la solution selon l'invention ;
- la figure 2 est un schéma simplifié d'un amplificateur à gain variable conforme à l'invention et réalisé à partir du circuit de la figure 1 ;
- la figure 3 est un schéma détaillé d'un exemple de réalisation de l'amplificateur à gain variable conforme à l'invention ;
- la figure 4 est un diagramme d'évolution en fonction du temps de la tension de commande des éléments réactifs de l'amplificateur conforme à l'invention ;
- la figure 5 est un schéma détaillé d'un exemple de réalisation d'un circuit de commande pour les éléments réactifs de l'amplificateur de l'invention ; et
- les figures 6 et 7 sont des diagrammes d'évolution du gain de l'amplificateur de l'invention en fonction de la fréquence, pour deux plages différentes de variation de capacité des varicaps associées à cet amplificateur.

La présente invention est décrite ici en référence à un amplificateur de signaux d'écho pour appareil à ultrasons, mais il est bien entendu qu'elle n'est pas limitée à cette seule application, et qu'elle peut être mise en oeuvre dans de nombreuses autres applications nécessitant un amplificateur à gain variable à large plage de variation de gain sur une large plage de fréquences, pour amplifier des signaux pouvant être de très faible niveau.

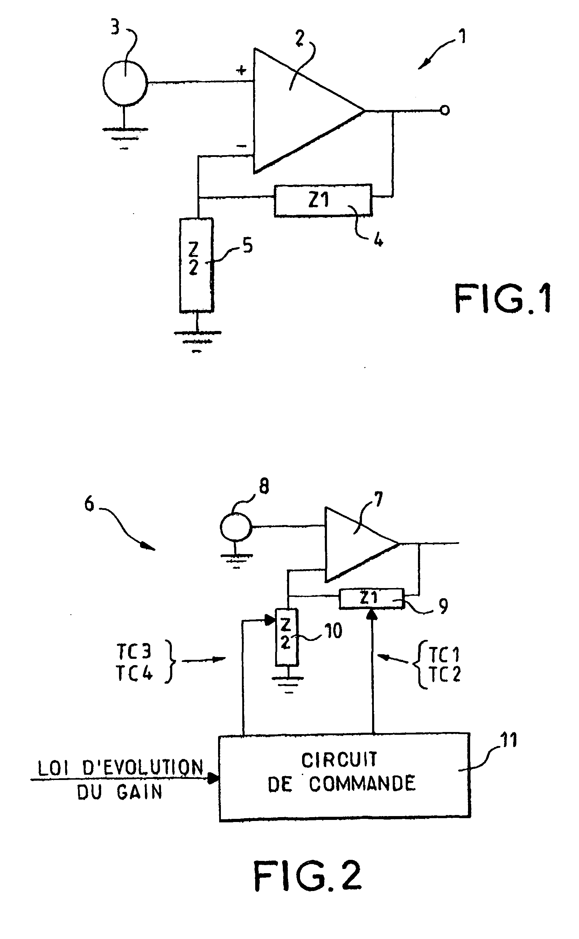

On a représenté en figure 1 un circuit 1 à amplificateur opérationnel 2 en montage classique, dont l'entrée non inverseuse reçoit d'un pôle d'une source 3, des signaux à amplifier, l'autre pôle de cette source étant relié à la masse, et dont l'entrée inverseuse est reliée à sa sortie par une réactance 4, d'impédance Z1. L'entrée inverseuse de l'amplificateur 2 est également reliée à la masse par une réactance 5, d'impédance Z2.

Il est bien connu que le gain G du circuit 1 est donné par : G = 1+ (Z1/Z2). Pour que ce circuit 1 se comporte en amplificateur à gain variable, il faut faire varier la valeur de l'impédance Z1 et/ou de l'impédance Z2. En général, la réactance 4 est du type à impédance variant en fonction d'une tension de commande. En général, la loi de variation de cette impédance n'est pas nécessairement linéaire en fonction des variations de la tension de commande. Le circuit produisant la tension de commande variable peut mémoriser la loi liant les variations de la tension de commande aux variations d'impédance. L'élément 4 peut être une résistance, mais en général c'est un élément capacitif.

Selon l'invention, les deux réactances 4 et 5 sont des éléments capacitifs dont la valeur de la capacité est variable et commandée en tension. De préférence, ce sont des diodes à capacité variable, dénommées « Varicaps ». Une diode Varicap est une diode dont la capacité intrinsèque varie fortement en fonction de la tension inverse qui lui est appliquée. Cette tension sera dénommée par la suite tension de commande V_{C}.

Selon une autre caractéristique de l'invention, les diodes Varicap utilisées en tant qu'éléments 4 et 5 sont apairées, une telle caractéristique étant importante pour la réalisation d'un circuit 1 intégré spécifique. En effet, il est bien connu que les valeurs des paramètres caractéristiques de composants présentent une dispersion importante dans une même série de fabrication, mais la tolérance sur le rapport des caractéristiques de deux composants similaires est toujours étroite. Grâce à cette caractéristique, le gain du circuit 1 avec des varicaps en tant qu'éléments 4 et 5 devient pratiquement indépendant de la série de fabrication dans laquelle sont prises les varicaps, du fait que ce gain dépend du rapport de deux composants similaires, pris dans une même série.

En outre, l'utilisation de deux réactances à impédance variable permet d'élargir la plage de variation du gain de l'amplificateur 1 à gain variable. En fait, lorsque la valeur de Z1 augmente, celle de Z2 diminue, et inversement.

Dans le circuit conforme à l'invention, l'étendue de la plage théorique de variation de gain est sensiblement égale au carré de l'étendue de celle du circuit de l'art antérieur à une seule varicap.

Le montage de l'invention présente une impédance d'entrée très élevée, ce qui fait que son gain est pratiquement indépendant de l'impédance de la source 3. La valeur de capacité de l'impédance Z2 peut être facilement choisie très basse (quelques dizaines de pF, par exemple), ce qui fait que même à des fréquences d'une dizaine de MHz, ou plus, son impédance reste très basse. La valeur de l'impédance Z1 peut alors être suffisamment basse pour qu'elle puisse être une varicap. II en résulte que le bruit de l'amplificateur 2 reste très bas.

On a représenté en figure 2 le schéma simplifié d'un amplificateur 6 à gain variable conforme à l'invention. Cet amplificateur 6 comporte les éléments 7 à 10, respectivement similaires aux éléments 2 à 5 de la figure 1, et un circuit 11 de commande de la tension inverse appliquée aux varicaps 9 et 10, c'est-à-dire fournissant ladite tension de commande V_{C}.

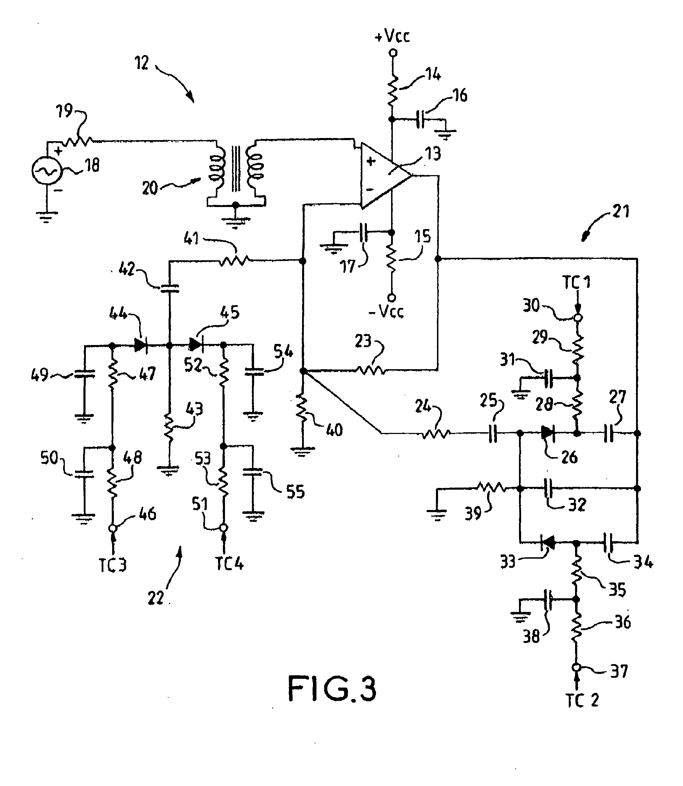

La figure 3 montre le schéma détaillé d'un exemple 12 de réalisation de la partie « amplificateur » (c'est-à-dire sans le circuit de commande 11) de l'amplificateur à gain variable 6 de la figure 2. Ce montage amplificateur 12 comporte un amplificateur opérationnel 13, alimenté de façon symétrique en étant relié d'un côté à une borne à tension d'alimentation +V_{CC}, et de l'autre à une borne à tension d'alimentation -V_{CC}. Une source 18 de signaux à amplifier (par exemple une sonde ultrasonore) est reliée à l'entrée non inverseuse de l'amplificateur 13 par une résistance série 19 et un transformateur 20.

L'entrée inverseuse de l'amplificateur 13 est reliée, d'une part, à sa sortie par un circuit 21, et d'autre part, à la masse (qui représente le pôle commun des tensions d'alimentation +V_{CC} et -V_{CC}) par un circuit 22. Ces circuits 21 et 22 correspondent respectivement aux réactances 9 et 10 de la figure 2.

Le circuit 21 comporte une résistance 23 branchée entre la sortie et l'entrée inverseuse de l'amplificateur 13. En parallèle sur la résistance 23, est branché un circuit série se composant d'une résistance 24, d'un condensateur 25, d'une diode varicap 26 et d'un condensateur 27. La cathode de la diode 26 est reliée par une résistance 28, en série avec une résistance 29, à une borne 30 sur laquelle est appliquée une première tension de commande de gain TC1. Le point commun des résistances 28 et 29 est relié à la masse par un condensateur 31. En parallèle sur le circuit série comportant la diode 26 et le condensateur 27, on branche d'une part un condensateur 32 et d'autre part un circuit série comportant une diode varicap 33 et un condensateur 34, la cathode de la diode 33 étant reliée à l'anode de la diode 26. Le point commun à l'anode de la diode 33 et au condensateur 34 est relié par une résistance 35 en série avec une autre résistance 37 à une borne 37. Une tension de commande de gain TC2 est appliquée à la borne 37. Le point commun des résistances 35 et 36 est relié à la masse par un condensateur 38. Le point commun au condensateur 25, aux diodes 28 et 35 et au condensateur 32 est relié à la masse par une résistance 39.

Le circuit 22 comporte d'une part une résistance 40 branchée entre l'entrée inverseuse de l'amplificateur 13 et la masse, et d'autre part un circuit série-parallèle composé des éléments 41 à 55 décrits ci-dessous. Ce circuit série-parallèle comporte une première branche série, branchée entre l'entrée inverseuse de l'amplificateur 13 et la masse et se composant, dans l'ordre, d'une résistance 41, d'un condensateur 42 et d'une autre résistance 43. Le point commun au condensateur 42 et à la résistance 43 est relié d'une part à la cathode d'une varicap 44 et d'autre part à l'anode d'une autre varicap 45. L'anode de la varicap 44 est reliée à une borne 46 par deux résistances en série 47 et 48, découplées chacune à la masse par un condensateur 49, 50 respectivement. Une tension de commande de gain TC3 est appliquée à la borne 46. De même, la cathode de la varicap 45 est reliée à une borne 51 par deux résistances en série 52, 53, découplées chacune à la masse par un condensateur 54, 55 respectivement. Une tension de commande de gain TC4 est appliquée à la borne 51.

Dans le circuit de la figure 3, afin d'éviter les influences néfastes de la distorsion harmonique, due à la dépendance de la capacitance des diodes varicap vis-à-vis de la tension qui leur est appliquée, on utilise deux diodes varicap pour chacun des circuits 21 et 22, chacune de ces diodes étant commandée, de façon connue en soi, par sa propre tension de commande continue, TC1 à TC4, ces diodes étant branchées en opposition l'une par rapport à l'autre et pouvant donc être commandées indépendamment l'une de l'autre par des tensions de polarités opposées. Dans le circuit 21, la résistance 39 assure la liaison à la masse pour les tensions TC1 et TC2, tandis que dans le circuit 22, c'est la résistance 43 qui joue ce rôle pour les tensions TC3 et TC4. Grâce à cette commande en sens opposés des deux varicaps dans chacun des circuits 21 et 22, on réduit la distorsion harmonique intrinsèque de ces diodes due à leur loi de variation de leur capacitance en fonction de la tension à leurs bornes.

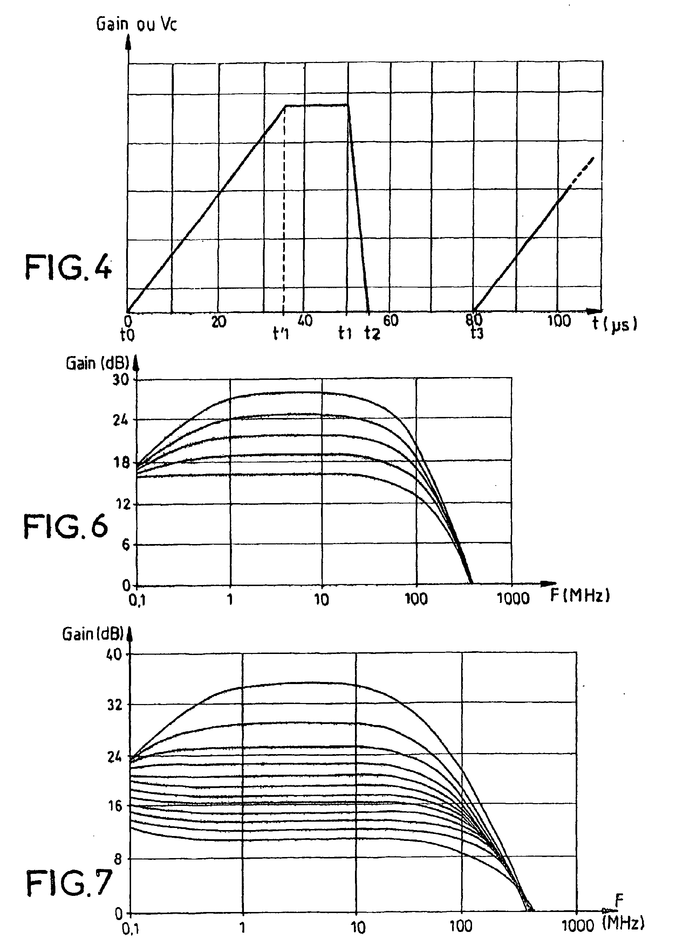

On a représenté en figure 4 un exemple d'évolution en fonction du temps de la tension de pilotage à partir de laquelle on produit les tensions de commande TC1 à TC4 (constituant chacune la tension V_{C} relative à chacune des varicaps), dans le cas où l'amplificateur à gain variable de l'invention est relié à une sonde ultrasonore. Ce gain doit être minimal au début de l'acquisition d'une ligne (t0), et augmenter ensuite jusqu'à un instant t1, en présentant éventuellement un palier, à partir d'une temps t'1, dû à une saturation du gain. A un instant t2, proche de t1, ce gain doit s'annuler jusqu'à un instant t3, à partir duquel recommence le même processus que celui ayant commencé en t0. Dans l'exemple considéré, t0 = 0,00 µs, t'1 = 35 µs, t1 = 50 µs, t2 = 55 µs et t3 = 80 µs.

Pour simplifier la description, on a supposé ici que la loi de variation du gain de l'amplificateur 13 coïncide avec la loi de variation des tensions de commande des varicaps. Ces tensions de commande sont habituellement fournies par un convertisseur numérique/analogique, ce qui permet en fait de produire n'importe quelle loi de variation des tensions de commande tenant compte des non-linéarités de la loi de variation de la capacité des diodes, et donc de la variation du gain de l'amplificateur en fonction de ces tensions de commande.

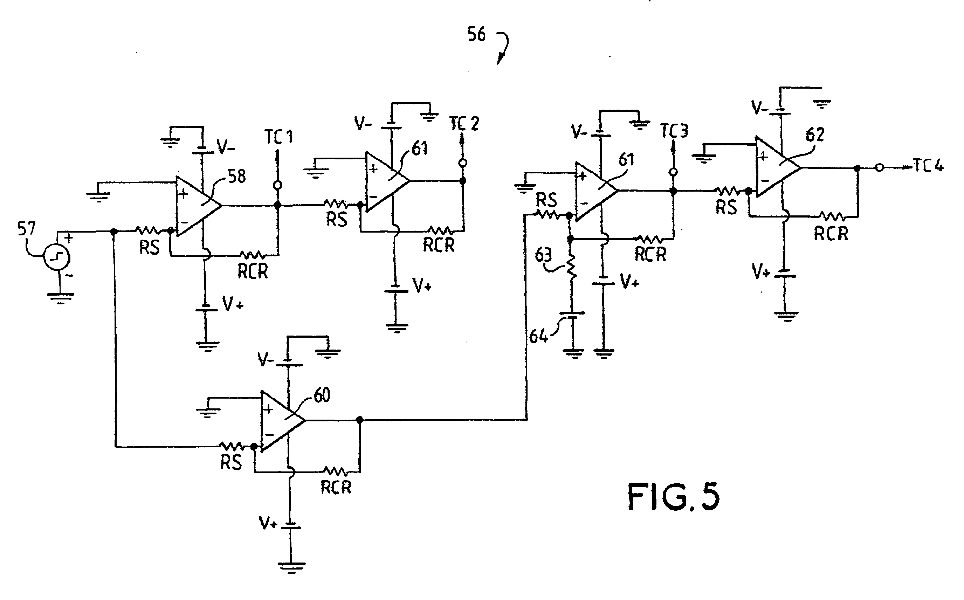

A partir d'une tension de pilotage telle que représentée en figure 4, on produit les quatre tensions TC1 à TC4 à l'aide d'un circuit tel que représenté par exemple en figure 5. TC1 doit être égale, en valeur absolue, à chaque instant, à TC2, mais de signe opposé, tandis que TC3 doit être égale en valeur absolue à TC4, mais de signe opposé. Il est à noter que pour obtenir un gain minimal, TC3 et TC4 doivent avoir une valeur absolue maximale à l'instant tₒ, ce qui correspond à la capacité minimale des varicaps 44 et 45. De façon similaire, pour obtenir un gain minimal à l'instant tₒ, les tensions TC1 et TC2 doivent avoir une valeur absolue minimale, ce qui correspond à une capacité maximale pour les varicaps 26 et 33. Il est également à noter qu'il suffit d'un seul circuit de pilotage pour tous les amplificateurs à gain variable d'une machine d'échographie par ultrasons, qui peut comporter habituellement 64 ou 128 tels amplificateurs.

On a représenté en figure 5 le schéma d'un exemple de réalisation d'un circuit de commande 56 pouvant fournir les tensions TC1 à TC4 à partir d'une unique tension de pilotage fournie par un générateur 57 (comportant, de façon connue en soi, un générateur numérique programmable et un convertisseur numérique/analogique). Le générateur 57 attaque directement un étage de commande comportant deux amplificateurs opérationnels 58, 59 fournissant les tensions TC1 et TC2, et par l'intermédiaire d'un amplificateur opérationnel auxiliaire 60, un deuxième étage de commande comportant les amplificateurs opérationnels 61, 62, qui fournissent les tensions TC3 et TC4. Tous les amplificateurs opérationnels 58 à 62 sont montés de la même façon : leur entrée non inverseuse est reliée à la masse, leur entrée inverseuse est attaquée via une résistance série RS et par une résistance de contre-réaction RCR, et ils sont alimentés symétriquement, chacun étant relié à une tension positive V+ et à une tension négative V-, par rapport à la masse. En outre, l'entrée inverseuse de l'amplificateur 61 est reliée à la masse par une résistance 63 en série avec une source de tension auxiliaire 64.

Selon un exemple de réalisation, les capacités des diodes varicap 44 et 45 varient entre 12pF et 36 pF, tandis que celles des diodes 26 et 33 varient entre 3 et 9 pF, pour des tensions TC1 à TC4 variant entre 0 V et 4,3 V environ. Il en résulte que le rapport entre la capacité la plus élevée et la capacité la plus faible des diodes varicap est de 3, ce qui permet de réaliser à la demande les amplificateurs à gain variable en technologie intégrée, BICmos, par exemple.

La figure 6 se rapporte à l'exemple de réalisation qui vient d'être cité. On y a représenté l'évolution du gain en dB d'un amplificateur à gain variable conforme à l'invention, en fonction de la fréquence, pour cinq différentes valeurs de rapport de capacités. Dans l'ordre croissant des gains dans leur partie utile sensiblement rectiligne, ces courbes correspondent respectivement à des varicaps de capacités maximales suivantes :
- Courbe à environ 16 dB de gain : pour Z1 : 9 pF et pour Z2 : 12 pF
- Courbe à environ 19 dB de gain : pour Z1 : 7,5 pF et pour Z2 : 18 pF
- Courbe à environ 21 dB de gain : pour Z1 : 6 pF et pour Z2 : 24 pF
- Courbe à environ 24,5 dB de gain : pour Z1 : 4,5 pF et pour Z2 : 30 pF
- Courbe à environ 28 dB de gain : pour Z1 : 3 pF et pour Z2 : 36 pF

Cette figure montre que la plage de fréquences utilisable (à 1dB d'atténuation) s'étend entre 2 et 15 MHz, et que le gain de l'amplificateur peut varier entre 16 et 27 dB.

Bien entendu, si les diodes varicap sont réalisées sous forme de composants discrets, leur capacité peut varier dans de plus larges proportions. On peut facilement atteindre un rapport de 20, ou même mieux, avec de tels composants discrets. Il en résulte, bien entendu, une plus large plage de variation de gain pour l'amplificateur de l'invention. On a représenté en figure 7 (similaire à la figure 6) des courbes d'évolution du gain de l'amplificateur pour un rapport de 20 entre valeurs extrêmes de la capacité des diodes varicap. Selon cet exemple de réalisation, la capacité des diodes 44 et 45 varie de 6 à 120 pF, tandis que celle des diodes 26 et 33 varie entre 3 et 60 pF. On y voit que la plage de fréquences utilisable, à 1 dB d'atténuation, s'étend entre 2 et 8 MHz environ, le gain variant entre 11 et 35 dB.

## Revendications

1. Dispositif amplificateur à gain variable et faible bruit pour des signaux d'entrée à dynamique supérieure à 100dB, relié à une source de signaux à amplifier, du type à amplificateur opérationnel (2), dont la sortie est reliée par un premier élément réactif (Z1) à une de ses entrées, cette entrée étant par ailleurs reliée par un deuxième élément réactif (Z2) à un pôle commun de l'alimentation de l'amplificateur, dans lequel l'amplificateur opérationnel comporte un amplificateur unique (7, 13) et que son entrée à laquelle sont reliés les deux éléments réactifs est son entrée inverseuse, et que son entrée non inverseuse est reliée à la source de signaux à amplifier et que les deux éléments réactifs sont des éléments à capacité variable (9, 10), **caractérisé en ce que**
chaque élément à capacité variable comportant au moins deux diodes varicap montées en sens inverses (26 et 33, 44 et 45) et commandées chacune par sa propre tension de commande (TC1 à TC4), ces tensions de commande évoluant symétriquement par rapport à un potentiel de référence.

2. Dispositif amplificateur selon la revendication 1, **caractérisé par le fait qu'**il est réalisé sous forme de circuit intégré à la demande.

3. Dispositif amplificateur selon la revendication 2, **caractérisé par le fait qu'**il est réalisé en technologie BICmos, les varicaps étant également intégrées.

4. Dispositif amplificateur selon la revendication 2, **caractérisé par le fait que** seules les varicaps sont réalisées sous forme de composants discrets.

## Patentansprüche

1. Rauscharme Verstärkervorrichtung mit variabler Verstärkung für Eingangssignale mit einem Dynamikumfang von über 100 dB, die mit einer Quelle von zu verstärkenden Signalen vom Typ Operationsverstärker (2) verbunden ist, deren Ausgang durch ein erstes reaktives Element (Z1) mit einem ihrer Eingänge verbunden ist, wobei dieser Eingang ferner durch ein zweites reaktives Element (Z2) mit einem gemeinsamen Stromversorgungspol des Verstärkers verbunden ist, wobei der Operationsverstärker einen einzelnen Verstärker (7, 13) umfasst und sein Eingang, mit dem die zwei reaktiven Elemente verbunden sind, sein invertierender Eingang ist, und wobei sein nicht invertierender Eingang mit der Quelle von zu verstärkenden Signalen verbunden ist und wobei die zwei reaktiven Elemente Elemente mit variabler Kapazität (9, 10) sind, **dadurch gekennzeichnet, dass**
jedes Element mit variabler Kapazität mindestens zwei in entgegengesetzten Richtungen montierte Kapazitätsdioden (26 und 33, 44 und 45) umfasst, die jeweils durch ihre eigene Steuerspannung (TC1 bis TC4) gesteuert werden, wobei diese Steuerspannungen sich in Bezug auf ein Bezugspotential symmetrisch verändern.

2. Verstärkervorrichtung nach Anspruch 1, **dadurch gekennzeichnet, dass** sie in Form einer anwendungsspezifischen integrierten Schaltung ausgebildet ist.

3. Verstärkervorrichtung nach Anspruch 2, **dadurch gekennzeichnet, dass** sie in BiCMOS-Technologie hergestellt ist, wobei die Kapazitätsdioden ebenfalls integriert sind.

4. Verstärkervorrichtung nach Anspruch 2, **dadurch gekennzeichnet, dass** nur die Kapazitätsdioden in Form von diskreten Komponenten ausgebildet sind.

## Claims

1. A variable gain and low-noise amplifier device for input signals with a dynamic range higher than 100dB, connected to a source of signals to be amplified, of the operational amplifier type (2), the output of which is connected via a first reactive element (Z1) to one of its inputs, said input also being connected via a second reactive element (Z2) to a common pole of the power supply of the amplifier, wherein said operational amplifier comprises a single amplifier (7, 13) and its input to which said two reactive elements are connected is its inverting input, and its non-inverting input is connected to the source of signals to be amplified, and said two reactive elements are variable-capacitance elements (9, 10), **characterised in that**
each variable-capacitance element comprises at least two varicap diodes mounted in reverse direction (26 and 33, 44 and 45) and each controlled by its own control voltage (TC1 to TC4), said control voltages evolving symmetrically relative to a reference potential.

2. The amplifier device according to claim 1, **characterised in that** it is produced in the form of a custom integrated circuit.

3. The amplifier device according to claim 2, **characterised in that** it is produced using BiCMOS technology, the varicaps also being integrated.

4. The amplifier device according to claim 2, **characterised in that** only the varicaps are produced in the form of discrete components.
